# EUROPEAN PATENT APPLICATION

(11) **EP 4 831 674 A1**
(43) Date of publication of application: **28.10.2026**
(21) Application number: 25171607.2
(22) Date of filing: 22.04.2025
(51) Int. Cl.: G01R 33/565, G01R 33/56, G01R 33/561

(54) **MAGNETIC RESONANCE IMAGING USING OPTIMIZED MOTION SENSING AND CORRECTION**

(71) Applicant: Koninklijke Philips N.V., 5656 AE Eindhoven (NL)
(72) Inventor: GOPALAKRISHNAN, Karthik, Eindhoven (NL); BECK, Gabriele, Eindhoven (NL); KASIREDDY, Viswanatha Reddy, 5656AG Eindhoven (NL); CHUNG, Hayley, Eindhoven (NL); KRISHNA, Chennakeshava, Eindhoven (NL)
(74) Representative: Philips Intellectual Property & Standards

(57) **Abstract**

The invention relates to a method of magnetic resonance (MR) imaging, comprising: acquiring two-dimensional, three-dimensional, four-dimensional respiratory or dynamic resolved, or five-dimensional respiratory and cardiac resolved k-space imaging data and at least one motion navigator including at least one of: motion sensing data from an external motion sensing device (19), one or more intrinsic image or k-space navigators, one or more additionally acquired image or k-space navigators. The method further comprises: analyzing the at least one motion navigator, wherein the analysis provides a local differentiation between different motion components, including respiratory, cardiac and non-periodic motion, to identify motion states for a least one of the motion components; using the identified motion states to process the k-space imaging data by selectively weighting, combining, rejecting, and/or correcting the k-space imaging data; and reconstructing a motion-corrected image based on the processed k-space imaging data. Moreover, the invention relates to an MR imaging system configured to perform the method.

## Description

### FIELD OF THE INVENTION

The present invention relates to the field of magnetic resonance (MR). It finds particular application in conjunction with MR imaging methods and MR scanners for diagnostic purposes, and will be described with particular reference thereto.

### BACKGROUND OF THE INVENTION

Magnetic resonance (MR) imaging is widely recognized for its superior ability to visualize soft tissues without the need for ionizing radiation. MR imaging is extensively used in medical diagnostics, providing detailed images that are crucial for accurate diagnosis and treatment planning. MR imaging methods generate images by exploiting the interactions between magnetic fields and nuclear spins within tissues. Despite the considerable advantages of MR imaging, patient and physiological motion during image acquisition pose significant challenges that compromise the quality and diagnostic reliability of the resulting images.

In conventional MR imaging, motion such as respiration, cardiac pulsations, and involuntary movements often result in image degradation, manifesting as blurring, ghosting, and various motion-related artifacts. These artifacts become even more pronounced and problematic in three-dimensional (3D) or higher dimensional imaging methods, like four-dimensional (4D) or five-dimensional (5D) MR imaging, which involve acquiring images over time to visualize physiological processes and anatomical movements. 4D or 5D MR imaging, commonly used for respiratory-resolved imaging and cardiac motion assessment, necessitates precise temporal and spatial alignment to effectively capture dynamic changes and motion cycles.

Traditional approaches for managing motion in MR imaging include respiratory gating, breath-holding, cardiac gating, motion binning and the use of external devices such as respiratory belts or camera-based sensors. Although these techniques mitigate motion artifacts to some extent, they often lack the precision and robustness required to fully correct for complex anatomical motions, especially in scenarios involving multiple independent motions or non-rigid deformations. Moreover, conventional gating approaches can lead to prolonged scan times, reduced patient comfort, and practical difficulties such as patient cooperation or sensor placement issues.

Additionally, intrinsic navigator techniques, where motion sensing signals are derived directly from the MR data acquisition, have been developed, offering improved integration into clinical workflows. However, intrinsic navigators alone often cannot sufficiently differentiate between respiratory, cardiac, and non-periodic motion components, leading to suboptimal correction and residual motion artifacts.

### SUMMARY OF THE INVENTION

From the foregoing it is readily appreciated that there is a need in MR imaging for improved motion management techniques capable of accurately distinguishing, quantifying, and compensating for complex and diverse anatomical motions, including non-rigid and multicomponent movements. It is thus an object of the invention to provide an improved method, system, and software for MR imaging that effectively senses, distinguishes, quantifies, and corrects multiple complex anatomical motions to enhance image quality, diagnostic accuracy, and patient comfort during MR examinations.

In accordance with the invention, a method of MR imaging is disclosed. The method comprises:
a) acquiring two-dimensional (2D), three-dimensional (3D), four-dimensional (4D) respiratory or dynamic resolved, or five-dimensional (5D) respiratory and cardiac resolved k-space imaging data and at least one motion navigator including at least one of:
   - motion sensing data from an external motion sensing device,
   - one or more intrinsic k-space navigators,
   - one or more additionally acquired k-space navigators;
b) analyzing the at least one motion navigator, wherein the analysis provides a local differentiation between different motion components, including respiratory, cardiac and non-periodic motion, to identify motion states for a least one of the motion components;
c) using the identified motion states to process the k-space imaging data by selectively weighting, combining, rejecting, and/or correcting the k-space imaging data; and
d) reconstructing a motion-corrected image based on the processed k-space imaging data.

The invention proposes a method for magnetic resonance (MR) imaging, involving the acquisition of 2D, 3D, 4D respiratory-resolved or dynamic, or 5D respiratory and cardiac-resolved k-space imaging data. The method specifically uses at least one motion navigator from an external motion sensing device, like a camera, or intrinsic or additionally acquired image or k-space navigator. The navigator signals are analyzed to identify different local motion states, explicitly distinguishing respiratory, cardiac, and non-periodic motions. The MR imaging data are processed through selective weighting, combination, rejection, or correction based on the identified motion states. This process, particularly the approach of separately determining the motion states for the different motion components, significantly enhances image quality and sharpness by removing or reducing motion artifacts, improving the diagnostic clarity and accuracy of MR images, particularly in 4D respiratory-resolved imaging where clear delineation of anatomical movements is crucial.

In an embodiment, the additionally acquired k-space navigator is a "trailing" navigator acquired immediately after imaging data acquisition with the (initial) acquisition direction changed to an expected main motion sensitizing direction, a flip angle of the k-space navigator being optionally adapted to improve the signal-to-noise ratio and T₁ sensitivity for consistent and robust motion detection, independent of magnetization preparation. The "trailing" navigator is a k-space navigator specifically acquired immediately after the main imaging acquisition, typically reoriented toward the expected main direction of anatomical motion, like in the feet head direction in case of breathing motion detection. The optional adjustment of the navigator's flip angle is performed to enhance the signal-to-noise ratio and improve T₁ sensitivity, thereby providing robust, sensitive and consistent motion detection regardless of magnetization preparation conditions.

Another embodiment incorporates simultaneous recording of the motion sensing data from an external motion-sensing device, typically a motion camera system, concurrently with the MR imaging data acquisition. The combined analysis of image or k-space navigators and external motion data significantly enhances the detection and differentiation of complex local motions. Integrating these two complementary sources (image or k-space navigators and external sensor signals) improves the accuracy and reliability of separating respiratory from cardiac and non-periodic motion components, ultimately providing better correction and image clarity.

In a further embodiment, motion estimates are derived from the identified motion states, wherein the motion estimates reflect occurring motion quantitatively, including at least one of displacement values, rotation angles, deformation magnitudes for the at least one motion component, wherein the motion estimates are used to process the k-space imaging data and/or reconstruct the motion-corrected image. These quantitative estimates allow precise, physically interpretable corrections of the acquired imaging data. By translating motion detection into quantitative motion estimates (e.g., using known voxel dimensions), the accuracy of motion correction significantly improves, leading to more precise anatomical delineation and better diagnostic reliability.

In yet another embodiment, multiple local receiving coil elements are used for acquiring the k-space imaging data, each associated with specific anatomical regions, to detect and quantify motion states. Utilizing the spatially localized sensitivity of each coil allows for precise region-specific motion detection. This approach is particularly beneficial when imaging different anatomical regions undergoing partially or fully independent motions, ensuring that motion correction is accurately tailored to localized anatomical dynamics. Combining locally detected and quantified motion states from the image or k-space navigators and (3D) external motion sensing device allows a robust, spatial and time-aligned correction of local motion, thereby significantly enhancing local image sharpness and reducing artifacts.

According to a further embodiment, the motion estimates include a motion vector field representing spatially varying motion characteristics across different anatomical regions. The motion vector field provides a detailed spatial representation of varying motion characteristics across different anatomical regions. The motion vector field precisely captures spatially nonuniform motions such as deformations or independent rigid motions of multiple anatomical structures. Its advantage is the significantly improved capability to correct complex, non-rigid anatomical movements, resulting in sharper images with clearer anatomical boundaries and improved diagnostic value.

According to another embodiment, the processing of the k-space imaging data includes region-specific per-coil motion correction for each anatomical region before combining k-space imaging data acquired via different coil elements. Correcting motion at the individual coil level and optionally spatially and temporally aligning with the motion signals from the external motion sensing device, provides superior precision in correcting motion-induced artifacts, particularly beneficial for imaging regions with distinct local dynamics.

In a further embodiment, k-space imaging data associated with motion states that exceed a predefined motion threshold is selectively rejected for each anatomical region separately. This embodiment notes the advantage of preventing heavily motion-corrupted data from negatively impacting the final image. This selective rejection strategy ensures consistently high-quality imaging outputs, even under conditions of extreme or sporadic anatomical movements.
In yet another embodiment, the reconstruction of the motion-corrected image includes spatially weighting the contributions of k-space imaging data acquired via different local receiving coil elements based on their respective identified motion states. This spatial weighting ensures that motion-compromised data contributes less to the final reconstruction, substantially improving the resulting image sharpness and consistency across anatomical regions.

According to a further embodiment, a spatially varying weighting function is applied across anatomical regions to ensure smooth transitions between motion-corrected anatomical regions. This prevents abrupt discontinuities or visible artifacts at the interfaces of regions corrected separately, thus achieving seamless integration and coherent high-quality imaging.

In possible embodiments, specific motion-robust k-space acquisition methods may be employed, including radial (stack of stars or KOOSH ball), spiral (stack of spirals or Cones), Cartesian sampling strategies like cartesian spirals (CASPR) or EPI, or 2D Propeller sequences. These acquisition methods are particularly advantageous for motion robust imaging and multiple dimensional imaging, given their inherent robustness against motion-related artifacts and their compatibility with retrospective respiratory binning techniques.

In another embodiment, provision is made for temporal synchronization of the external motion sensors and the used MR acquisition system, especially through timestamping data from both sources. Accurate synchronization between MR and camera data significantly enhances motion correlation and thus improves the accuracy of motion correction, especially beneficial for high-temporal-resolution multi-dimensional imaging.

Yet further embodiments employ machine learning to identify the motion states and/or to derive the motion estimates and/or to correct the k-space imaging data and/or to reconstruct the motion-corrected image. A deep leaming network, preferably a generative adversarial network (GAN) but also latest versions like 3D patch-based ResVoxGAN or 3D Patch-based Transformer U-Net, can be used which is trained to synthesize a motion-corrected image from the k-space imaging data in combination with the determined motion states or the derived motion vector field for specific motion components and/or suppress k-space imaging data from local coils corrupted by pulsatile motion. Machine learning, and specifically deep leaming approaches such as GANs and transformers for motion and vector field estimation, are advantageously employed to enhance the identification, quantification, correction, and reconstruction of complex anatomical motion. In the context of the invention, the GAN network can be trained on combined and synchronized complex data comprising the intrinsic k-space navigators and the external motion sensing data, thereby leveraging complementary strengths of intrinsic MR signal detection and external monitoring. By integrating both independent internal (navigator) and external (motion sensor) motion information into a single deep leaming architecture, the invention allows synthesizing and significantly refining local motion sensing data, thereby providing more precise and robust differentiation and quantification of individual anatomical motion components such as breathing, cardiac pulsation, and non-periodic movements. The network effectively "cleans up" and improves the reliability of the motion sensing information by automatically identifying and suppressing noise, interference, and artifacts, leading to more accurate motion characterization than traditional approaches. Specifically, the GAN or transformer approaches can extract local motion characteristics in the form of detailed motion vector fields per motion component. The availability of accurate motion vector fields significantly improves the reliability and precision of the subsequent motion correction. The networks further facilitates intelligent processing of imaging data by selectively weighting pulsatile-corrupted k-space data acquired via strongly affected individual receiving coil elements, enabling effective suppression or rejection of compromised imaging data. This targeted weighting approach greatly reduces the influence of pulsatile artifacts (e.g., cardiac pulsation) on final images, directly enhancing image clarity and diagnostic quality. Additionally, the networks can actively perform data correction by effectively synthesizing local, motion-free imaging data. The (GAN-based) networks synthesizes a sharp, geometrically aligned, motion-corrected image dataset by directly incorporating the quantified motion vector fields and corresponding corrected k-space imaging data. The GAN's generative capabilities inherently promote superior preservation of fine anatomical structures, edge sharpness, and geometrical coherence, overcoming limitations typically associated with conventional motion correction and reconstruction techniques.

According to a further embodiment, the external motion sensing device is a camera. The camera can be configured to capture three-dimensional (3D) motion data, preferably for tracking respiratory and/or cardiac motion and/or non-periodic motion of a subject. The camera can be, e.g., an infrared, structured-light, stereo-vision, or time-of-flight camera. The camera advantageously provides accurate, comfortable, non-contact patient monitoring. The camera integration improves the overall robustness and accuracy of the motion detection system.

In still a further embodiment, the frequency spectrum of the motion sensing data is analyzed to identify characteristic frequency bands of different motion components, including respiratory and cardiac motion and non-periodic motion. A "patient specific" frequency bandpass filter can be defined based on the characteristic frequency band of a selected motion component and is applied in the step of identifying the motion states of this motion component from the k-space navigators to eliminate contributions from an unwanted motion component. The frequency bandpass filter can be applied to isolate respiratory motion by removing cardiac motion contributions. This embodiment involves a sophisticated analysis of the frequency spectrum of the acquired motion sensing data (particularly data from external motion-sensing devices such as cameras), in order to precisely characterize and separate the various motion components - specifically respiratory motion, cardiac pulsation, and potentially other non-periodic motion signals - based on their distinct frequency characteristics. The frequency spectrum analysis refers to a computational technique whereby time-domain motion signals, obtained from the external monitoring devices are mathematically transformed (commonly using a Fourier transform or similar frequency domain transformation) into a frequency-domain representation. This transformation reveals characteristic frequency bands that are uniquely associated with specific physiological motions. For instance, respiratory motion typically occurs within lower frequency ranges (e.g., approximately 0.1-0.5 Hz), whereas cardiac motion is found within comparatively higher frequency ranges (typically about 0.6-2.0 Hz). Other sporadic or non-periodic patient movements may occupy varying or broader frequency ranges. Once these distinct frequency bands for the specific motion components are identified, a dedicated frequency bandpass filter is defined and applied accordingly. The term bandpass filter specifically refers to a computational filter configured to selectively preserve only signals within a predefined range of frequencies (the "passband"), while suppressing or eliminating signals outside this frequency range (the "stopband"). Such a frequency bandpass filter is constructed around the characteristic frequency band of the selected motion component (for example, the respiratory frequency band), thus accurately isolating the desired physiological motion. The practical advantage of employing this frequency-based filtering technique is that it effectively eliminates unwanted interference from other motions. It can suppress or remove cardiac motion contamination from respiratory motion estimates or vice versa. This results in a more accurate motion state identification. The "patient specific" targeted filtering significantly improves the accuracy, reliability, and robustness of subsequent image processing steps, such as selective data weighting, rejection, and correction, thereby providing sharper, clearer, and diagnostically more accurate MR images.

According to a further embodiment, the motion states are identified using a motion-sensitized weighted computation of the center of mass position in navigator images reconstructed from the individual k-space navigator signals, which weighted center of mass computation assigns higher weights to image components corresponding to mobile anatomical regions while reducing the influence of static background regions. The weights can be selected that maximize the variance of the computed center of mass positions across a number of acquisitions of the k-space navigators. The weights used in the center of mass computation can be computed per local receiving coil element. This approach aims at enhancing the sensitivity and accuracy of the anatomical motion detection. It addresses the common problem of conventional center-of-mass-based motion estimation being compromised by static or less mobile anatomical structures, which often dominate navigator signals and thus mask subtle but clinically significant movements of smaller, more mobile structures. The traditional approach for detecting anatomical motion from MR navigator signals involves calculating a simple center of mass position across the entire navigator image or region. However, this simple method often results in inaccurate or significantly underestimated motion estimates when large, static anatomical regions dominate the signal. Such static or minimally moving anatomical background regions generate strong but motion-insensitive signals, consequently overshadowing weaker signals from smaller or dynamically moving anatomical regions. Thus, the presence of static background anatomy causes traditional center-of-mass motion detection methods to significantly underrepresent true anatomical motion, substantially degrading accuracy. To address this limitation, the invention proposes a refined and advanced method, termed motion-sensitized weighted computation of the center of mass, explicitly assigning higher weighting factors to image regions or pixels that correspond to anatomically mobile regions, while simultaneously reducing or minimizing the weights of static or less mobile anatomical background regions. In practice, each pixel or voxel within the navigator image is multiplied by a specific weighting factor prior to computing the center of mass position. By carefully selecting these weights, mobile anatomical regions, which provide the most clinically relevant motion information, dominate the center-of-mass calculation. Static or less mobile regions, which would otherwise obscure the actual motion signals, have significantly reduced influence on the resulting motion estimate. These weighting factors can be specifically determined by optimizing (maximizing) the variance of the computed center-of-mass positions across a series of multiple navigator acquisitions. This optimization principle leverages the insight that true anatomical motion naturally exhibits significant temporal variability (high variance) in navigator images taken at different time points, whereas static background regions show very little variance. Thus, optimizing weights to maximize the variance ensures that the motion detection algorithm selectively emphasizes precisely those anatomical regions which display the greatest motion sensitivity. This statistically-based optimization results in significantly enhanced sensitivity, accuracy, and reliability of motion estimation, capturing subtle movements with substantially higher fidelity compared to conventional approaches. Since the navigator signals are typically acquired using multiple receiving coils positioned around the patient, each coil element inherently has spatially unique sensitivity to different anatomical structures and different regions of the anatomy. Optimizing weighting factors separately per coil element ensures that each coil's distinct spatial sensitivity is maximally leveraged to detect local motion. By applying coil-specific weights, the resulting motion estimates become more accurate and finely tuned, effectively capturing subtle local movements within different anatomical sub-regions. This coil-specific optimization substantially enhances local sensitivity, enabling the precise characterization and correction of anatomically complex, spatially varying, and non-rigid motions.

The method of the invention can be advantageously carried out in most MR environments in clinical use at present. To this end it is merely necessary to utilize a computer program by which the computer to be used is controlled such that it performs the above-explained method steps of the invention. The computer program may be present either on a data carrier or be present in a data network so as to be downloaded for installation in the computer, e.g., the control computer of an MR imaging system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR imaging system for carrying out the method of the invention;
Fig. 2 shows diagrams of navigator and motion camera signals and their respective frequency spectra;
Fig. 3 shows diagrams of a filtered and unfiltered navigator-derived motion trace;
Fig. 4 shows a flow diagram illustrating the method of the invention;
Fig. 5 shows anatomical images acquired and reconstructed conventionally (left) and according to the method of the invention (right).

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

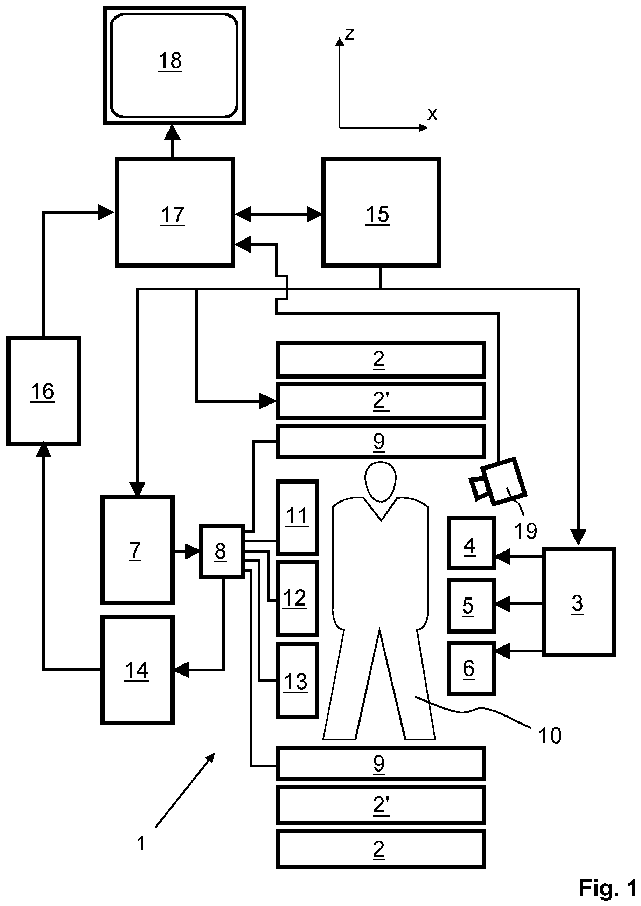

With reference to Fig. 1, an MR imaging system 1 is shown. The MR imaging system 1 includes an MR scanner comprising superconducting or resistive main magnet coils 2 such that a substantially uniform, temporally constant main magnetic field B₀ is created along a z-axis through an examination volume. The scanner further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of radiofrequency (RF) pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR pulse sequence is composed of a packet of RF pulse segments of short duration which taken together with each other and any applied magnetic field gradients achieve a selected manipulation of nuclear magnetic resonance.

Any of the MR imaging sequences according to the invention, as well as other MR imaging sequences known in the art or protocols may be stored in a memory. The memory is intended to represent any combination of memory or storage device which is accessible to a computational system and/or processor comprised therein, configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A control computer 15 constitutes a processing unit controlling the current flow through the shimming coils 2' as well as the gradient pulse amplifier 3 and the transmitter 7 to generate any of a plurality of MR pulse sequences, such as echo planar imaging (EPI), echo volume imaging, gradient and spin echo imaging, fast spin echo imaging, and the like in conformity with a pre-determined examination protocol. For the respective examination protocol, the receiver 14 receives a single or a plurality of MR data lines in rapid succession following each RF excitation pulse. The functionality of the control computer may be provided by one or more control processors.

A data acquisition system 16 performs analog-to-digital conversion of the received signals and converts each MR data line to a digital format suitable for further processing. In modem MR scanners the data acquisition system 16 is a separate computer which is specialized in acquisition of raw image data. The functionality of the data acquisition system may be provided by one or more data acquisition processors.

The digital raw image data is reconstructed into an image representation by a reconstruction unit 17 which applies a Fourier transform or other appropriate reconstruction algorithms, such like SENSE or SMASH. The functionality of the reconstruction unit may be provided by one or more reconstruction processors. The MR image may represent a planar slice through the patient, an array of parallel planar slices, a three-dimensional volume, or the like. The image is then stored in a memory where it may be accessed for converting slices, projections, or other portions of the image representation into appropriate format for visualization, for example via a video monitor 18 which provides a man-readable display of the resultant MR image. The display screen 18 may be integrated in the MR imaging system and/or may be a separate display device such a display screen, a tablet, smartphone, etc.

In some embodiments the functionalities of the control computer 15, the data acquisition system 16 and the reconstruction unit 17 are implemented in one computer system or their functionalities are provided by a processor or a network of processors.

To achieve accurate motion characterization and correction, the MR imaging system 1 combines information obtained from intrinsic k-space navigators with external motion sensing data recorded by a motion camera 19. The analysis begins with extracting time-resolved motion traces from both sources. The motion camera 19 provides a continuous motion signal representing the temporal evolution of anatomical movement, such as chest or abdominal expansion and contraction during respiration. Because the camera 19 operates with high temporal resolution and is unaffected by internal physiological noise, such as cardiac pulsation, it serves as a clean reference signal for respiratory motion.

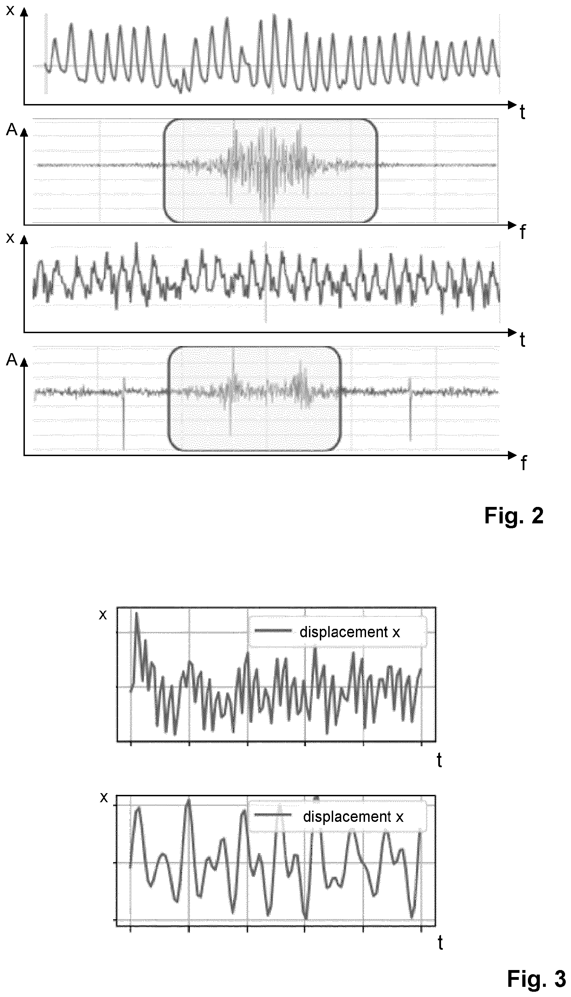

To enable the differentiation between multiple physiological motion components - such as respiratory and cardiac motion - the system performs a frequency-based analysis of the motion trace derived from the motion camera 19. As shown in Fig. 2, the top diagram illustrates a representative motion signal (motion-induced displacement in direction x) recorded by the motion camera 19 as a function of time t. This signal typically reflects primarily the respiratory motion of the subject, as the camera 19 is largely insensitive to internal motion components such as cardiac pulsation.

The second diagram in Fig. 2 shows the corresponding frequency spectrum (amplitude A as a function of frequency f) of the motion camera signal, which is obtained by transforming the time-domain signal into the frequency domain, e.g., via a Fourier transform. **In** this spectrum, the dominant frequency band corresponding to the respiratory motion is clearly visible. A rectangular overlay indicates the characteristic frequency range of the respiratory component, for example between approximately 0.1 and 0.5 Hz.

The third diagram in Fig. 2 shows a motion signal derived from a k-space navigator acquired via one of the local receiving coil elements 11, 12, 13. Unlike the motion camera signal, the navigator-based motion trace reflects a superposition of multiple physiological motions - primarily respiratory motion and cardiac pulsation - as both influence the position and shape of internal anatomy as a function of time. Accordingly, the bottom diagram of Fig. 2 displays the frequency spectrum of this navigator-derived motion signal. The same rectangular overlay corresponding to the respiratory motion frequency (as identified from the camera signal) is shown. The spectrum also clearly exhibits spectral components at higher frequencies (peaks to left and right of the rectangle), corresponding to cardiac motion.

Based on the frequency spectrum of the camera-derived signal, a bandpass filter is defined that isolates the frequency band of the selected motion component - in this case, the respiratory motion. This filter is then applied to the navigator-derived motion signal to suppress undesired contributions, such as cardiac pulsation.

This is illustrated in Fig. 3. The top diagram shows the original motion trace derived from the k-space navigator, which includes both respiratory and cardiac components. The bottom diagram in Fig. 3 shows the corresponding motion trace after applying the bandpass filter that suppresses the respiratory band, effectively isolating the cardiac component of the motion signal. The filtered navigator signal thus represents a clean trace of cardiac motion, free from respiratory contributions.

This frequency-based filtering approach enables the MR system 1 to flexibly isolate and analyze specific motion components in the presence of multiple overlapping physiological motions. Depending on the application, the method may be used to extract either the respiratory motion component (by suppressing cardiac frequencies) or the cardiac motion component (by suppressing respiratory frequencies) or both. This filtered motion signal is then used in the subsequent identification of motion states, such as determining the phase within a respiratory or cardiac cycle (e.g., end-expiration, systole, etc.) attributed to a specific image frame.

Following the filtering step, the system 1 performs motion state identification, which refers to determining the instantaneous phase of the selected motion component (e.g., inhale, exhale, or intermediate state in the respiratory cycle). To this end, the filtered navigator signal is analyzed using peak detection or phase-tracking algorithms to define motion cycles. Each frame in the k-space imaging sequence is thereby assigned to a specific motion state of the target motion component. This enables retrospective motion binning, i.e. the association of acquired k-space lines with discrete respiratory phases, which is a prerequisite for motion-compensated reconstruction.

The k-space data is then processed based on the identified motion states. In one approach, data from similar motion state, i.e. acquired during comparable respiratory phases, is selectively combined to improve signal-to-noise ratio while preserving motion coherence. In another case, k-space data acquired during irregular or corrupted motion states, such as deep breathing outliers or abrupt shifts, is selectively rejected based on a predefined motion threshold derived from the filtered motion trace. Moreover, data is weighted based on the proximity of its associated motion state to a desired reference state (e.g., end-expiration), with smoother transitions ensured by continuous rather than binary weighting schemes.

Further refinement is achieved by correcting for detected motion through spatial transformations. For example, phase correction, deformation fields, or spatial registration can be applied to adjust k-space data so that all data points are spatially aligned to a common anatomical configuration, reducing residual motion blur. The nature of these corrections may depend on the quantitative motion estimates derived from the weighted center of mass computation or other navigator-based motion parameters from intrinsic, camera or combined motion estimates.

Once the motion-aware processing of the k-space data is complete, the final image is reconstructed. A conventional Fourier transform or an advanced reconstruction algorithm (e.g., parallel imaging techniques like SENSE or GRAPPA) is applied to the processed k-space dataset. Because the included data has been filtered, aligned, and optimized with respect to the motion state, the resulting image exhibits significantly reduced motion artifacts and improved anatomical sharpness. This method is particularly advantageous for 4D imaging applications, such as respiratory-resolved MR, where multiple motion states can be reconstructed separately or a single, motion-suppressed image can be synthesized for clinical evaluation.

To further enhance the accuracy of motion estimation from the k-space navigators, a motion-sensitized weighted computation of the center of mass is applied, which overcomes the limitations of conventional center of mass approaches to derive the momentary motion-induced displacement from the navigator image. Traditional methods that compute the center of mass based on the unweighted image intensity distribution often fail when a static anatomical background dominates the signal, thereby obscuring the motion of smaller but mobile anatomical structures. To address this limitation, the present invention introduces spatial weighting into the computation, allowing higher influence from image regions associated with motion and reduced influence from largely immobile background structures.

Let *I_{x,s,c}* denote the modulus image value at pixel position x in the navigator image for the shot s and local coil number (channel) *c*. Let *w_{x,c}* be a spatial weighting factor for pixel x and channel c. The weighted center of mass *M_{s,c}* for shot s and channel c is then computed as: ${M}_{s , c} = \left({\sum }_{x} {w}_{x , c} ⋅ x ⋅ {I}_{x , s , c}\right) / \left({\sum }_{x} {w}_{x , c} ⋅ {I}_{x , s , c}\right)$ This equation shifts the center of mass toward the parts of the navigator image that are both signal-intense and weighted for motion relevance. The spatial weights *w_{x,c}* are selected to emphasize anatomical regions expected to undergo motion. In one embodiment, a set of basis weighting functions is predefined - such as rectangular window functions covering different navigator regions - and a final weighting function is constructed as a linear combination of these basis weights. The coefficients of this linear combination are optimized such that the temporal variance of *M_{s,c}* over multiple shots s is maximized: $max \left\{{w}_{x , c}\right\} {Var}_{s} \left({M}_{s , c}\right)$ This maximization ensures that the weighting function emphasizes regions with high motion sensitivity, as mobile anatomical structures contribute more to temporal variance than static regions.

To ensure stability and suppress noise, the weighting functions can be selected to have a minimum width (e.g., 20% of the size of the image domain), and overlapping basis regions may be used to improve coverage. The optimization can be performed independently for each coil channel *c*, thereby adapting to the spatial sensitivity of each local receiving coil and further enhancing local motion detection.

The resulting motion traces *M_{s,c}* from multiple receiving coil channels can then be filtered - using, for example, the bandpass filtering method described above - and combined to derive a robust, composite motion signal. These refined motion traces, based on the weighted center of mass estimation, are used for motion state identification and to guide the subsequent processing of the k-space imaging data.

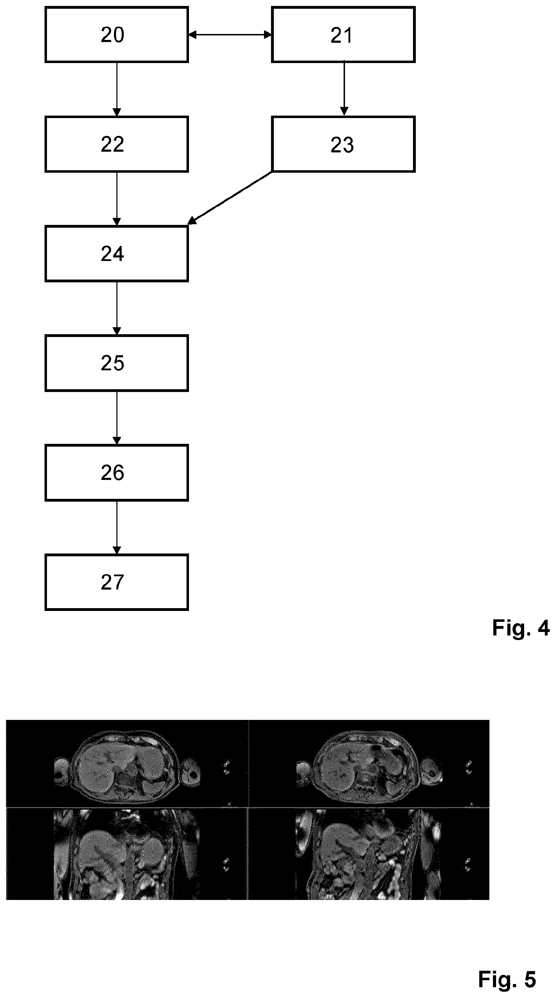

Fig. 4 illustrates a flow diagram of the method according to the invention. The method starts in step 20 with the acquisition of k-space imaging data from a plurality of local receiving coil elements 11, 12, 13, including at least one intrinsic or additionally acquired k-space navigator. In parallel, external motion sensing data is recorded in step 21 - preferably using the motion camera system 19 configured to track body surface motion indicative of physiological processes such as breathing and cardiac activity.

A critical feature of the invention, as represented in Fig. 4 by the double arrow, is the temporal synchronization between these two data sources: the k-space navigator signals and the external motion sensing data. To ensure accurate alignment of motion events across both domains, the invention employs a timestamping mechanism. Each k-space navigator shot is associated with a precise acquisition timestamp, typically derived from the system clock or pulse sequence timing of the MR system 1. Simultaneously, the motion camera 19 assigns timestamps to each captured frame or motion signal sample, preferably with sub-second precision and using the same or a synchronized timebase. This enables precise temporal alignment between navigator acquisitions and the corresponding segments of the external motion trace.

Once the synchronized data is available, motion traces are extracted from both the navigator signals and the motion sensing data in steps 22 and 23 respectively. The external motion trace serves as a reference for distinguishing physiological motion components by frequency analysis as described above. Based on this analysis, a motion component - such as respiratory motion - is selected, and the corresponding frequency band is isolated using a bandpass filter. This filter is then applied to the navigator-based motion traces for each coil channel in step 24 to eliminate unwanted motion components (e.g., cardiac pulsation) and to isolate the target motion.

Following the separation of motion components, the system proceeds to identify the motion states in step 25. This step involves assigning each point in time to a specific phase within the motion cycle of the selected component. For example, in the case of respiratory motion, the system detects periodic features such as peaks in the filtered motion trace and defines a respiratory cycle. Based on this cycle, discrete motion states (e.g., end-inhalation, mid-expiration) are defined and assigned to the respective time points of navigator and imaging data.

The identified motion states of the different identified motion components are then used in step 26 to process the k-space imaging data. For each local receiver channel, the data is binned or grouped according to the corresponding motion state. This allows combining k-space data acquired during similar motion configurations, while rejecting or down-weighting data from inconsistent or corrupted motion states. Additionally, motion correction transformations, such as phase correction or deformation alignment, may be applied to align data acquired during different motion states to a common reference configuration.

An aspect of the invention is the channel-specific processing of motion and imaging data. Because each coil element 11, 12, 13 is sensitive to a different spatial region within the field of view, the corresponding navigator signal captures locally specific motion patterns. To exploit this, the invention performs motion estimation and motion-state assignment separately for each receiver channel, allowing localized correction of non-rigid motion - particularly in cases where different anatomical regions move independently. Camera based synthesis and extraction of motion states from different spatial region within the field of view allows an improved temporal aligned motion vector field analysis.

After channel-specific processing, the resulting data can be combined in step 27 producing a final image that is corrected for spatially complex motion.

In a possible embodiment, machine learning techniques, and in particular deep learning architectures such as generative adversarial networks (GANs) or transformers, are employed in at least some of the steps 22-27 to achieve a high accuracy and robustness of the overall motion correction process. The network can be trained on synchronized input data comprising k-space navigators and external motion traces, enabling it to learn mappings between motion states and artifact-free anatomical appearances. The network can enhance motion state identification, derive high-resolution motion vector fields, suppress or reject corrupted k-space data (e.g., due to cardiac pulsation), and reconstruct sharp, geometrically accurate images. In case of 4D respiratory resolved or 5D respiratory and cardiac resolved imaging, next to reconstructing 4D and 5D motion aligned data sets, motion vector fields for example can also be applied to the reconstructed 3D image data set. By integrating internal and external motion information, the deep leaming network can effectively denoise and refine motion estimates and contribute to the reconstruction of high-quality motion-corrected MR images.

To summarize, the described embodiment of the method of the invention combines timestamped synchronized acquisition of MR imaging data and external motion sensor signals, motion component-specific motion state identification, channel-specific motion binning and correction, and - optionally - deep leaming based intelligent reconstruction to provide robust and spatially precise compensation of physiological motion in MR imaging.

Fig. 5 illustrates a comparative set of anatomical images demonstrating the advantages of the present invention in the context of motion-compensated MR imaging. The left side images are acquired using a conventional 3D navigator-synchronized TFE (Turbo Field Echo) imaging sequence. In this approach, the motion state is typically determined by thresholding or gating on the basis of internal pencil beam navigator echoes. While this can suppress some motion-related artifacts, it results in uneven treatment of static and dynamic anatomical regions, as well as residual blurring in motion-sensitive structures due to imperfect gating or undersampling. In contrast, the right side images of Fig. 5 are acquired and reconstructed according to the method of the invention, incorporating synchronized acquisition of external motion sensing data, motion-state identification, and motion based phase correction incorporating cardiac and breathing motion, as described above. These images demonstrate a significant improvement in visual clarity, especially in anatomical areas affected by physiological motion. A key observation in the right images is the balanced preservation of sharpness and anatomical fidelity across both static and moving structures. This is made possible by the method's ability to assign motion states to each data point using synchronized analysis of external motion signals and intrinsic k-space navigator data, followed by selective weighting, binning, but especially the spatial motion correction based on the identified motion state. Moreover, the vessel structures in the thoracoabdominal region such as the hepatic veins, portal branches, or pulmonary vasculature appear significantly sharpened in the right-hand images. These vessels, which are typically blurred in conventional images due to uncompensated motion, are now clearly delineated as a result of the motion correction enabled by the external motion sensor. The external signal allows precise tracking of the respiratory cycle, facilitating highly targeted phase correction and alignment of k-space data even during deep or irregular breathing. The visual improvement in the right side images of Fig. 5 confirms the effectiveness of the invention in capturing and compensating for complex motion patterns, while maintaining the spatial integrity of stationary anatomical regions. These results underline the clinical value of the invention, particularly for high-resolution imaging in anatomically challenging regions such as the liver, diaphragm, or upper abdomen, where both static and dynamically moving tissues must be faithfully resolved.

It is understood that one or more of the aforementioned embodiments of the invention may be combined as long as the combined embodiments are not mutually exclusive.

In summary, the described embodiments demonstrate how the method of the invention effectively resolves the problem of coordinate inconsistency between motion-compensated image sub-volumes acquired in separate scans. By anchoring all reconstructions to a common reference frame, the method ensures spatial coherence of the resulting images and enables reliable diagnostic interpretation and post-processing.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as "system." Furthermore, aspects of the present invention may take the form of a computer program product embodied in one or more computer readable medium(s) having computer executable code embodied thereon, which computer executable code when executed by a computational system, causes the computational system to control a magnetic resonance imaging system and to perform any of the method embodiments of the invention.

## Claims

1. A method of magnetic resonance, MR, imaging, comprising:
acquiring two-dimensional, three-dimensional, four-dimensional respiratory or dynamic resolved, or five-dimensional respiratory and cardiac resolved k-space imaging data and at least one motion navigator including at least one of:
motion sensing data from an external motion sensing device (19),
one or more intrinsic image or k-space navigators,
one or more additionally acquired image or k-space navigators;
analyzing the at least one motion navigator, wherein the analysis provides a local differentiation between different motion components, including respiratory, cardiac and non-periodic motion, to identify motion states for a least one of the motion components;
using the identified motion states to process the k-space imaging data by selectively weighting, combining, rejecting, and/or correcting the k-space imaging data; and
reconstructing a motion-corrected image based on the processed k-space imaging data.

2. Method of claim 1, wherein the additionally acquired k-space navigator is a trailing navigator acquired immediately after imaging data acquisition with the initial acquisition direction being optionally changed to an expected main motion sensitizing direction, a flip angle of the k-space navigator being optionally adapted to improve the signal-to-noise ratio and T₁ sensitivity for consistent and robust motion detection, independent of magnetization preparation.

3. Method of claim 1 or 2, wherein the motion sensing data from the external motion sensing device (19) is recorded simultaneously with the acquisition of the k-space imaging data, wherein the combined analysis of the k-space navigators and the motion sensing data is used to improve the motion analysis and wherein the combined analysis provides an improved differentiation between different local motion components to identify motion states for a least one of the motion components.

4. Method of any one of claims 1 to 3, wherein motion estimates are derived from the identified motion states, wherein the motion estimates reflect occurring motion quantitatively, including at least one of displacement values, rotation angles, deformation magnitudes for the at least one motion component, wherein the motion estimates are used to process the k-space imaging data and/or reconstruct the motion-corrected image.

5. Method of any one of claims 1 to 4, wherein the k-space imaging data is acquired using a plurality of local receiving coil elements, each associated with a different anatomical region, wherein motion states are identified separately for each anatomical region from the k-space navigators acquired via the respective local receiving coil element and from the motion sensing data.

6. Method of claim 4 or 5, wherein the motion estimates include a motion vector field representing spatially varying motion characteristics across different anatomical regions.

7. Method of claim 5 or 6, wherein the processing of the k-space imaging data includes region-specific per-coil motion correction for each anatomical region before combining k-space imaging data acquired via different coil elements.

8. Method of any one of claims 5 to 7, wherein the reconstruction of the motion-corrected image includes spatially weighting the contributions of k-space imaging data acquired via different local receiving coil elements based on their respective identified motion states.

9. Method of any one of claims 1 to 8, wherein the frequency spectrum of the motion sensing data is analyzed to identify characteristic frequency bands of different motion components, including respiratory and cardiac motion.

10. Method of claim 9, wherein a frequency bandpass filter is defined based on the characteristic frequency band of a selected motion component and is applied in the step of identifying the motion states of this motion component from the k-space navigators to eliminate contributions from an unwanted motion component.

11. Method of claim 10, wherein the frequency bandpass filter is applied to isolate respiratory motion by removing cardiac motion contributions.

12. Method of any one of claims 1 to 11, wherein the motion states are identified using a motion-sensitized weighted computation of the center of mass position in navigator images reconstructed from the individual k-space navigator signals, which weighted center of mass computation assigns higher weights to image components corresponding to mobile anatomical regions while reducing the influence of static background regions.

13. Method of claim 12, wherein the weights are selected that maximize the variance of the computed center of mass positions across a number of acquisitions of the k-space navigators.

14. Method of claim 12 or 13, wherein the weights used in the center of mass computation are computed per local receiving coil element.

15. A magnetic resonance, MR, imaging system comprising:
an MR scanner (1) configured to acquire MR imaging data of a patient's anatomy;
a processor (15, 16, 17) operatively connected to the MR scanner (1) and configured to:
acquire two-dimensional, three-dimensional, four-dimensional respiratory or dynamic resolved, or five-dimensional respiratory and cardiac resolved k-space imaging data and at least one motion navigator including at least one of:
motion sensing data from an external motion sensing device (19),
one or more intrinsic image or k-space navigators,
one or more additionally acquired image or k-space navigators;
analyze the at least one motion navigator, wherein the analysis provides a local differentiation between different motion components, including respiratory, cardiac and non-periodic motion, to identify motion states for a least one of the motion components;
use the identified motion states to process the k-space imaging data by selectively weighting, combining, rejecting, and/or correcting the k-space imaging data; and
reconstruct a motion-corrected image based on the processed k-space imaging data.
